Europäisches Patentamt

European Patent Office

Office européen des brevets

(19)

(11) **EP 0 999 250 B1**

(12) **EUROPEAN PATENT SPECIFICATION**

(45) Date of publication and mention
of the grant of the patent:
**31.03.2004 Bulletin 2004/14**

(51) Int Cl.⁷: **C09J 7/02**, H01L 21/68,
B24B 37/04

(21) Application number: **99308819.4**

(22) Date of filing: **05.11.1999**

(54) **Pressure sensitive adhesive sheet for use in semiconductor wafer working**

Druckempfindlicher Klebefilm zur Verwendung in der Halbleiterwaferbearbeitung

Film adhésif autocollant utilisé pour le traitement de plaquettes semi-conductrices

(84) Designated Contracting States:
**DE FR GB IT**

(30) Priority: **06.11.1998 JP 31605998**

(43) Date of publication of application:
**10.05.2000 Bulletin 2000/19**

(73) Proprietor: **Lintec Corporation**
**Tokyo 173-0001 (JP)**

(72) Inventors:
 • **Kondo, Takeshi**
 **Urawa-shi, Saitama 336-0026 (JP)**
 • **Takahashi, Kazuhiro**
 **Kawaguchi-shi, Saitama 333-0866 (JP)**
 • **Mineura, Yoshihisa**
 **Itabashi-ku, Tokyo 173-0022 (JP)**

(74) Representative: **Towler, Philip Dean et al**
**Frank B. Dehn & Co.,**
**European Patent Attorneys,**
**179 Queen Victoria Street**
**London EC4V 4EL (GB)**

(56) References cited:
 **EP-A- 0 768 354      EP-A- 0 798 355**

 • **PATENT ABSTRACTS OF JAPAN vol. 1995, no.
 05, 30 June 1995 (1995-06-30) & JP 07 045557 A
 (LINTEC CORP), 14 February 1995 (1995-02-14)**
 • **DATABASE WPI Section Ch, Week 198728
 Derwent Publications Ltd., London, GB; Class
 A18, AN 1987-196498 XP002144375 & JP 62
 127376 A (NITTO ELECTRIC IND CO), 9 June
 1987 (1987-06-09)**

## Description

The present invention relates to a method for grinding the back of a semiconductor wafer. More particularly, the present invention relates to a method for grinding the back of semiconductor wafers to an extremely small thickness.

BACKGROUND OF THE INVENTION

In recent years, the spread of IC cards is being promoted, and accordingly the reduction of the thickness thereof is increasingly demanded. Thus, it is now needed to reduce the thickness of semiconductor chips from the conventional about 350 μm to 50 - 100 μm or less. Also, an increase of wafer diameter has been studied for realizing a productivity enhancement.

It is common practice to grind a wafer back after the formation of a circuit pattern on a wafer surface. The grinding of the wafer back is performed while a pressure sensitive adhesive sheet is stuck to the circuit surface to thereby protect the circuit surface and fix the wafer. Pressure sensitive adhesive sheets comprising a soft substrate coated with a pressure sensitive adhesive are commonly employed in this use. However, in these pressure sensitive adhesive sheets based on a soft substrate, the tension occurred at the sticking is stored as a residual stress. When the wafer has a large diameter or is ground to an extremely small thickness, the residual stress of the pressure sensitive adhesive sheet is superior to the strength of the wafer with the result that the wafer is warped by the force exerted to cancel the residual stress. Further, after the grinding, the brittleness of the wafer, when supported by a soft substrate, has caused wafer breakage during the carrying of the wafer.

Therefore, the use of a hard substrate as a substrate of a pressure sensitive adhesive sheet employed to protect thin wafers and large-diameter wafers is being studied.

However, when peeling of pressure sensitive adhesive sheet comprising a hard substrate, the force applied at the time of peeling is conveyed to the wafer due to the rigidity of the substrate to thereby invite the danger of damaging the wafer that has become brittle. For solving this problem, it has been studied to use an energy radiation curable pressure sensitive adhesive as the above pressure sensitive adhesive so that peeling of the pressure sensitive adhesive sheet comprising a hard substrate can be facilitated. However, even when use is made of the energy radiation curable pressure sensitive adhesive, the peeling force cannot completely be eliminated with the result that there remains the danger of damaging the wafer.

The polyethylene terephthalate film commonly employed as a hard substrate generally shrinks when heated. In the wafer back grinding of recent years, mechanical grinding with the use of a grinder is often followed by chemical polishing such as etching. In the chemical polishing, the temperature of the wafer may be raised to about 80°C by a heat of reaction. This temperature rise may cause the pressure sensitive adhesive sheet comprising a heat shrinkable substrate such as the polyethylene terephthalate film to shrink with the result that the wafer is warped.

EP-A2-0798355 describes an adhesive tape and inter alia its use in the back-grinding of semiconductor wafers. It does not address the problems of grinding the back of wafers to extremely small thicknesses.

OBJECT OF THE INVENTION

The present invention has been made in view of the above state of the prior art. It is an object of the present invention to provide a method for grinding the back of a semiconductor wafer having a surface furnished with a circuit pattern, which enables grinding thin wafers and large-diameter wafers at the back side thereof until the wafers have an extremely small thickness without curving the wafers.

SUMMARY OF THE INVENTION

The present invention relates to a method for grinding the back of a semiconductor wafer having a surface furnished with a circuit pattern, said method comprising;

sticking onto the circuit surface of the wafer, a pressure sensitive adhesive sheet comprising a substrate and, superimposed thereon, a pressure sensitive adhesive layer, wherein said pressure sensitive adhesive sheet exhibits a one-minute-later stress relaxation ratio, at 10% elongation, of at least 40% in a tensile test, and grinding the back of the wafer to reduce the thickness of the wafer to 50 - 200 μm.

The above pressure sensitive adhesive sheet preferably has a Young's modulus ranging from $3.0 \times 10^7$ to $5.0 \times 10^9$ Pa.

Further, the substrate preferably has a Young's modulus and a thickness whose multiplication product is in the range of $1.0 \times 10^3$ to $1.0 \times 10^7$ N/m. Still further, it is preferred that the pressure sensitive adhesive layer is composed of a pressure sensitive adhesive whose elastic modulus at 23°C is in the range of $5.0 \times 10^4$ to $1.0 \times 10^8$ Pa.

The above method according to the present invention enables grinding semiconductor wafers at the back side thereof until the wafers have an extremely small thickness without warping the wafers.

DETAILED DESCRIPTION OF THE INVENTION

The present invention will be described in greater detail below.

The pressure sensitive adhesive sheet for use in the method according to the present invention comprises a substrate and, superimposed thereon, a pressure sensitive adhesive layer.

The pressure sensitive adhesive sheet is excellent in stress relaxation properties. In particular, the pressure sensitive adhesive sheet exhibits a one-minute-later stress relaxation ratio, at 10% elongation, of at least 40%, preferably at least 50%, and still preferably at least 60%, in a tensile test. The higher the stress relaxation ratio, the greater the favorable effects attained. The upper limit of stress relaxation ratio is theoretically 100%. The upper limit of stress relaxation ratio may occasionally be 99.9%, or 99%, or 95%.

The pressure sensitive adhesive sheet for use in the method according to the present invention is excellent in stress relaxation properties, so that the residual stress is decreased as soon as the pressure sensitive adhesive sheet is stuck to an adherend. Therefore, even the wafer having the pressure sensitive adhesive sheet stuck thereto an having been ground to an extremely small thickness to thereby become brittle can not be held warped because of the extremely small residual stress of the pressure sensitive adhesive sheet.

The stress relaxation ratio is measured in the following manner. That is, a sample of pressure sensitive adhesive sheet of a given length is stretched at a rate of 200 mm/min, and the stress A exerted at 10% elongation and the stress B exerted one minute after the termination of elongation are measured. The stress relaxation ratio is calculated by the formula:

$$(A-B)/A \times 100 \ (\%).$$

The Young's modulus (measured in accordance with Japanese Industrial Standard (JIS) K-7127) of the pressure sensitive adhesive sheet is preferably in the range of $3.0 \times 10^7$ to $5.0 \times 10^9$ Pa, still preferably $5.0 \times 10^7$ to $1.0 \times 10^9$ Pa, and optimally $6.0 \times 10^7$ to $8.0 \times 10^8$ Pa.

When the Young's modulus falls within the above ranges, the step of cutting the pressure sensitive adhesive sheet stuck to the wafer in conformity with the shape of the wafer can be streamlined.

As described later, in the present invention, the pressure sensitive adhesive layer may be composed of an energy radiation (energy beam) curable pressure sensitive adhesive. In this case, the above stress relaxation ratio and Young's modulus mean the values exhibited prior to the energy radiation curing of the pressure sensitive adhesive layer.

With respect to the substrate of the pressure sensitive adhesive sheet for use in the method of the present invention, the multiplication product of the thickness and Young's modulus thereof is preferably in the range of $1.0 \times 10^3$ to $1.0 \times 10^7$ N/m, still preferably $3.0 \times 10^3$ to $5.0 \times 10^6$ N/m, and optimally $5.0 \times 10^3$ to $3.5 \times 10^6$ N/m.

The thickness of the substrate is preferably in the range of 30 to 1000 µm, still preferably 50 to 800 µm, and optimally 80 to 500 µm.

The substrate is composed of a resin film, the type of which is not particularly limited as long as the above properties are exhibited. The above properties may be exhibited by either the resin per se or the resin blended with additives. The substrate may be prepared by either forming a curable resin into a film and curing the film or forming a thermoplastic resin.

For example, a photocurable resin or a thermosetting resin is used as the curable resin. Preferred use is made of a photocurable resin.

The photocurable resin is preferably selected from among, for example, resin compositions whose principal component is a photopolymerizable urethane acrylate oligomer.

This urethane acrylate oligomer can be obtained by reacting an isocyanate-terminated urethane prepolymer which is obtained by reacting a polyester or polyether type polyol compound with a polyisocyanate compound such as 2,4-tolylene diisocyanate, 2,6-tolylene diisocyanate, 1,3-xylylene diisocyanate, 1,4-xylylene diisocyanate or diphenylmethane-4,4'-diisocyanate, with a hydroxyl group containing acrylate or methacrylate such as 2-hydroxyethyl acrylate, 2-hydroxyethyl methacrylate, 2-hydroxypropyl acrylate, 2-hydroxypropyl methacrylate, polyethylene glycol acrylate or polyethylene glycol methacrylate. This urethane acrylate oligomer has a photopolymerizable double bond in its molecule and undergoes polymerization and curing when irradiated with light to thereby form a film.

The molecular weight of urethane acrylate oligomers preferably used in the present invention is in the range of 1000 to 50,000, especially 2000 to 30,000. These urethane acrylate oligomers can be used either individually or in combination.

It is often difficult to obtain a film only from the above urethane acrylate oligomer. Thus, films are generally obtained by diluting the urethane acrylate oligomer with a photopolymerizable monomer, conducting a film formation and curing the film. The photopolymerizable monomer has a photopolymerizable double bond in its molecule, and, in the present invention, preferred use is made of an acrylic ester compound having a relatively bulky group.

The photopolymerizable monomer employed for diluting the urethane acrylate oligomer is, for example, selected from among:

alicyclic compounds such as isobornyl (meth)acrylate, dicyclopentenyl (meth)acrylate, dicyclopentanyl (meth)acrylate, dicyclopentenyloxy (meth)acrylate, cyclohexyl (meth)acrylate and adamantane (meth)acrylate;
aromatic compounds such as phenylhydroxypropyl acrylate and benzyl acrylate; and
heterocyclic compounds such as tetrahydrofurfuryl (meth)acrylate, morpholinyl acrylate, N-vinylpyrrolidone and N-vinylcaprolactam. According to necessity, use may be made of polyfunctional (meth)acrylates.

The above photopolymerizable monomer is preferably added in an amount of 5 to 900 parts by weight, still preferably 10 to 500 parts by weight, and optimally 30 to 200 parts by weight to 100 parts by weight of the urethane acrylate oligomer.

In the forming of the substrate from the above photocurable resin, the time spent for photopolymerization and the photoirradiation dose can be reduced by mixing a photopolymerization initiator into the resin.

This photopolymerization initiator can be a photoinitiator such as a benzoin compound, an acetophenone compound, an acylphosphine oxide compound, a titanocene compound, a thioxanthone compound or a peroxide compound, or a photosensitizer such as an amine or a quinone. Specific examples thereof include 1-hydroxycyclohexyl phenyl ketone, benzoin, benzoin methyl ether, benzoin ethyl ether, benzoin isopropyl ether, benzyl diphenyl sulfide, tetramethylthiuram monosulfide, azobisisobutyronitrile, dibenzyl, diacetyl and $\beta$-chloroanthraquinone.

The photopolymerization initiator is preferably added in an amount of 0. 05 to 15 parts by weight, still preferably 0.1 to 10 parts by weight, and optimally 0.5 to 5 parts by weight, to 100 parts by weight of the resin total.

In the production of the above curable resin, oligomer and monomer can be selected from among various combinations so that the above properties can be realized.

The above resin may be blended with additives, for example, inorganic fillers such as calcium carbonate, silica and mica, metal fillers such as iron and lead, and colorants such as pigments and dyes.

With respect to the substrate film forming method, for example, the substrate can be produced by a method comprising casting a liquid resin (for example, precure resin or resin solution) onto, for example, a casting sheet in the form of a thin coating and subsequently conducting given steps for film formation. In this method, the stress loaded on the resin during the film formation is small, so that the occurrence of fish eye is reduced. Moreover, the uniformity of the film thickness is high and the thickness precision generally falls within 2%.

Another preferred method of forming a film comprises calendering or extrusion forming with the use of T die or inflation.

Corona treatment or superimposition of another layer such as a primer may be effected on the surface of an upper side, namely the side furnished with the pressure sensitive adhesive layer, of the substrate in order to enhance the adherence to the pressure sensitive adhesive.

The pressure sensitive adhesive sheet used in the present invention is produced by superimposing the pressure sensitive adhesive layer on the above substrate. When the pressure sensitive adhesive layer is composed of an ultraviolet curable pressure sensitive adhesive, use is made of a transparent substrate.

In the present invention, the elastic modulus at 23°C of the pressure sensitive adhesive constituting the above pressure sensitive adhesive layer is preferably in the range of $5.0 \times 10^4$ to $1.0 \times 10^8$ Pa, still preferably $7.0 \times 10^4$ to $8.0 \times 10^7$ Pa, and optimally $8.0 \times 10^4$ to $5.0 \times 10^7$ Pa. When the pressure sensitive adhesive layer is composed of an energy radiation curable pressure sensitive adhesive described later, the elastic modulus means that exhibited prior to the energy radiation curing.

Although depending on the type of material constituting the pressure sensitive adhesive layer, the thickness of the pressure sensitive adhesive layer is generally in the range of about 3 to 100 $\mu$m, preferably about 10 to 50 $\mu$m.

The pressure sensitive adhesive layer can be formed from various conventional pressure sensitive adhesives. These pressure sensitive adhesives are not limited at all, examples of which include rubber, acrylic, silicone and polyvinyl ether based pressure sensitive adhesives. Further, use can be made of energy radiation curable, heat foaming and hydrophilic pressure sensitive adhesives. Of these, energy radiation curable pressure sensitive adhesives are especially preferred in the present invention.

The energy radiation curable pressure sensitive adhesive generally contains an acrylic pressure sensitive adhesive and an energy radiation polymerizable compound as main components.

For example, low-molecular-weight compounds having in the molecule thereof at least two photopolymerizable carbon to carbon double bonds that can be converted into a three-dimensional network structure by light irradiation as disclosed in Japanese Patent Laid-open Publication Nos. 60(1985)-196,956 and 60(1985)-223,139 are widely used as the energy radiation polymerizable compounds to be incorporated in the energy radiation curable pressure sensitive adhesives. Specific examples thereof include trimethylolpropane triacrylate, tetramethylolmethane tetraacrylate, pentaerythritol triacrylate, pentaerythritol tetraacrylate, dipentaery-thritol monohydroxypentaacrylate, dipentaerythritol hexaacrylate, 1,4-butylene glycol diacrylate, 1,6-hexanediol diacrylate, polyethylene glycol diacrylate and commercially available oligoester acrylates.

Furthermore, besides the above acrylate compounds, urethane acrylate oligomers can be used as the energy radiation polymerizable compounds. Urethane acrylate oligomers can be obtained by reacting an isocyanate-terminated urethane prepolymer which is obtained by reacting a polyester or polyether type polyol compound with a polyisocyanate compound such as 2,4-tolylene diisocyanate, 2,6-tolylene diisocyanate, 1,3-xylylene diisocyanate, 1,4-xylylene diisocyanate or diphenylmethane-4,4-diisocyanate, with a hydroxyl group containing acrylate or methacrylate, such as 2-hydroxyethyl acrylate, 2-hydroxyethyl methacrylate, 2-hydroxypropyl acrylate, 2-hydroxypropyl methacrylate, polyethylene glycol acrylate or polyethylene glycol methacrylate.

With respect to the blending ratio of energy radiation polymerizable compound to acrylic pressure sensitive adhesive in the energy radiation curable pressure sensitive adhesive, it is preferred that 50 to 200 parts by weight, especially 50 to 150 parts by weight, and still especially 70 to 120 parts by weight, of the energy radiation polymerizable compound be used per 100 parts by weight of the acrylic pressure sensitive adhesive. In this instance, the initial adhesive strength of the obtained pressure sensitive adhesive sheet is large, and the adhesive strength is sharply decreased upon irradiation of the pressure sensitive adhesive layer with energy radiation. Accordingly, the peeling at the interface of the wafer and the energy radiation curable pressure sensitive adhesive layer to be performed after the completion of wafer back grinding is facilitated.

The energy radiation curable pressure sensitive adhesive may be composed of an energy radiation curable copolymer having an energy radiation polymerizable group as a side chain. This energy radiation curable copolymer simultaneously exhibits satisfactory adherence and energy radiation curability properties. Details of the energy radiation curable copolymer having an energy radiation polymerizable group as a side chain are described in, for example, Japanese Patent Laid-open Publication Nos. 5(1993)-32,946 and 8(1996)-27,239.

The above acrylic energy radiation curable pressure sensitive adhesive possesses satisfactory adhesive strength to the wafer before irradiation with energy radiation, and the adhesive strength is extremely decreased upon irradiation with energy radiation. That is, the acrylic energy radiation curable pressure sensitive adhesive enables bonding the wafer with the pressure sensitive adhesive sheet with satisfactory adhesive strength to thereby attain a surface protection before irradiation with energy radiation, but, after irradiation with energy radiation, enables easily peeling the sheet from the ground wafer.

The hydrophilic pressure sensitive adhesive can be selected from among, for example, pressure sensitive adhesives disclosed in Japanese Patent Application No. 9(1997)-30172. These pressure sensitive adhesives include compositions each comprising a copolymer prepared from a carboxyl group containing monomer and another monomer that is copolymerizable with the carboxyl group containing monomer, a neutralizer and a crosslinking agent.

Examples of suitable carboxyl group containing monomers include acrylic acid, methacrylic acid, crotonic acid, itaconic acid, maleic acid and fumaric acid. Examples of suitable other monomers that are copolymerizable with the carboxyl group containing monomers include alkoxy group-containing (meth)acrylic esters such as 2-methoxyethyl (meth)acrylate, 2-ethoxyethyl (meth)acrylate, 3-methoxybutyl (meth)acrylate and 2-butoxyethyl (meth)acrylate, and (meth)acrylic esters whose alkyl group has 1 to 18 carbon atoms.

The neutralizer is added to neutralize some or all of the carboxyl groups of the above copolymer so that hydrophilicity is imparted to the pressure sensitive adhesive composition. An organic amino compound such as monoethylamine, monoethanolamine, diethylamine, diethanolamine, triethylamine, triethanolamine or N,N,N'-trimethylethylenediamine is used as the neutralizer.

The crosslinking agent is added to partially crosslink the above copolymer. The crosslinking agent can be selected from among, for example, epoxy crosslinking agents, isocyanate crosslinking agents, methylol crosslinking agents, chelating crosslinking agents and aziridine crosslinking agents.

The amount of adhesive residue left at the time of peeling the pressure sensitive adhesive sheet is extremely small in the use of the above hydrophilic pressure sensitive adhesive. Moreover, hydrophilicity is imparted to the pressure sensitive adhesive polymer per se, so that the pressure sensitive adhesive is excellent in water washability to thereby enable washing away any portion of pressure sensitive adhesive left stuck to the wafer only with the use of pure water.

The pressure sensitive adhesive sheet used in the present invention can be obtained by coating a substrate in appropriate thickness with the above pressure sensitive adhesive according to the customary technique employing a knife coater, a roll coater, a gravure coater, a die coater, a reverse coater or the like and drying the pressure sensitive adhesive to thereby form a pressure sensitive adhesive layer on the substrate. When considered necessary, a release liner is applied onto the pressure sensitive adhesive layer.

The above pressure sensitive adhesive sheet is used to protect the surface of various adherends. For example, the pressure sensitive adhesive sheet is suitable to the use as a surface protective sheet in the storage, transportation or working of extremely thin semiconductor wafers, especially to the use as a protective pressure sensitive adhesive sheet for protecting a circuit surface during the polishing of wafer back to an extremely small thickness.

In the step of grinding the back of a semiconductor wafer with the use of a pressure sensitive adhesive sheet, first, the pressure sensitive adhesive layer of the pressure sensitive adhesive sheet is stuck to a wafer surface. The wafer surface is furnished with a circuit pattern. This sticking step is conducted by the use of a device known as a laminator in such a manner that tensions are minimized, but conducting the sticking with the complete avoidance of tensions is practically infeasible. Therefore, in the use of conventional pressure sensitive adhesive sheets, the tensions are stored as a residual stress in the pressure sensitive adhesive sheets. However, in the use of the pressure sensitive adhesive sheet used in the present invention, any internal stress is decreased by the stress relaxation.

Subsequently, the back of the wafer is ground to a given thickness by means of a grinder, etc., optionally followed by chemical polishing such as etching. During this procedure, not only is the wafer fixed by the pressure sensitive adhesive sheet but also the wafer surface contacting the pressure sensitive adhesive layer is simultaneously protected by the pressure sensitive adhesive sheet.

The thickness of the wafer is reduced to 50 - 200 μm by the above grinding. In the use of conventional pressure sensitive adhesive sheets, the tension at sticking is stored as a residual stress in the pressure sensitive adhesive sheets as mentioned above to thereby cause warping of extremely thin wafers. However, in the use of the pressure sensitive adhesive sheet used in the present invention, any internal stress is decreased by the stress relaxation, so that, even if the wafer is ground to an extremely small thickness, the wafer is free from warping.

Thereafter, when the pressure sensitive adhesive layer is composed of an energy radiation curable pressure sensitive adhesive, the pressure sensitive adhesive sheet on its back (substrate side) is irradiated with energy radiation so that the adhesive strength of the pressure sensitive adhesive layer is reduced, and the pressure sensitive adhesive sheet is peeled from the wafer.

EFFECT OF THE INVENTION

As apparent from the foregoing, the method for grinding the back of a semiconductor wafer according to the present invention enables grinding the back of semiconductor wafers, in particular large-diameter wafers, to an extremely small thickness without causing warping of the wafers.

EXAMPLE

The present invention will further be illustrated below with reference to the following Examples which in no way limit the scope of the invention.

In the following Examples and Comparative Examples, the "Young's modulus", "elastic modulus", "stress relaxation ratio" and "wafer warpage" are measured by the following methods.

"Young's modulus":

measured at a test speed of 200 mm/min in accordance with Japanese Industrial Standard (JIS) K7127.

"Elastic modulus" G':

measured by the torsional shear method, wherein, specimen: cylinder of 8 mm diameter x 3 mm height, instrument: Dynamic Analyzer RDA II (manufactured by Reometric), and
frequency: 1 Hz.

"Stress relaxation ratio":

Specimens of 15 mm width and 100 mm length are cut out from each of the pressure sensitive adhesive sheets of the Examples and Comparative Examples. The specimens are stretched at a rate of 200 mm/min by means of Tensilon RTA-100 manufactured by Orientec Corporation, and the stress A exerted at 10% elongation and the stress B exerted one minute after the termination of elongation are measured. The stress relaxation ratio is calculated by the formula:

$$(A-B)/A \times 100 \ (\%).$$

"Wafer warpage":

Each of the pressure sensitive adhesive sheets produced in the Examples and Comparative Examples is stuck to a Si wafer (200 mm diameter and 750 μm thickness) by the use of tape mounter (Adwill RAD-3500 manufactured by Lintec Corporation). Thereafter, the Si wafer is ground to a thickness of 150 μm by means of DFG-840 manufactured by Disco Corporation. After the completion of the grinding, without removing the pressure sensitive adhesive sheet, the wafer is placed, with its tape side up, on a first class planarity surface plate for precision inspection according to JIS B 7513.

Measuring is conducted at 17 measuring points, with the surface plate regarded as zero spot. The degree of warpage is a difference between the maximum value and the minimum value.

Furthermore, after the completion of the grinding conducted in the same manner, the wafer having the pressure sensitive adhesive sheet stuck thereto is immersed in 80 °C hot water for 10 min, and, without removing the pressure sensitive adhesive sheet, the wafer warpage is measured in the same manner.

Example 1

50 parts by weight of urethane acrylate oligomer having a weight average molecular weight of 5000 (produced by Arakawa Chemical Industry Co., Ltd.), 25 parts by weight of isobornyl acrylate, 25 parts by weight of phenylhydroxypropyl acrylate, 2.0 parts by weight of photopolymerization initiator (Irgacure 184 produced by Ciba-Geigy) and 0.2 part by weight of phthalocyanine pigment were blended together, thereby obtaining a photocurable resin composition.

PET film (produced by Toray Industries, Inc., thickness: 38 μm) as a casting sheet was coated with the above resin composition at a thickness of 110 μm according to the fountain die technique, thereby forming a resin composition layer. Immediately after the coating, the resin composition layer was laminated with the same PET film and thereafter irradiated with ultraviolet rays emitted from a high pressure mercury lamp (160 W/cm, height 10 cm) at a dose of 250 mJ/cm$^2$ so that the resin composition layer was crosslinked and cured. The PET films of both sides were peeled off, thereby obtaining a substrate film of 110 μm thickness. The Young's modulus of this substrate film was measured by the above method. The results are given in Table 1.

One side of this substrate film was coated with a pressure sensitive adhesive composition prepared by blending together 100 parts by weight of acrylic pressure sensitive adhesive (copolymer of n-butyl acrylate and acrylic acid), 120 parts by weight of urethane acrylate oligomer whose molecular weight was 8000, 10 parts by weight of crosslinking agent (diisocyanate compound) and 5 parts by weight of photopolymerization initiator (benzophenone compound) , and dried so that a pressure sensitive adhesive layer of 20 μm thickness was formed. Thus, a pressure sensitive adhesive sheet was obtained. The elastic modulus of the pressure sensitive adhesive layer was 1.5 x 10$^5$ Pa.

The stress relaxation ratio and Young's modulus of the thus obtained pressure sensitive adhesive sheet were measured by the above methods. The results are given in Table 1.

Furthermore, the obtained pressure sensitive adhesive sheet was subjected to a wafer warpage test. The results are given in Table 1.

Example 2

The same procedure as in Example 1 was repeated except that N-vinylcaprolactam was used in place of phenylhydroxypropyl acrylate. The results are given in Table 1.

Example 3

The same procedure as in Example 1 was repeated except that 50 parts by weight of isobornyl acrylate was used and phenylhydroxypropyl acrylate was not used. The results are given in Table 1.

Example 4

100 parts by weight of acrylic copolymer produced from 91 parts by weight of 2-methoxyethyl acrylate and 9 parts by weight of acrylic acid was blended with 4.75 parts by weight (0.2 mol per mol of carboxyl group) of triethanolamine as a neutralizer and subsequently 1.5 parts by weight (0.03 mol per mol of carboxyl group) of epoxy crosslinking agent (Tetrad C produced by Mitsubishi Gas Chemical Co., Inc.), and agitated well. Thus, a hydrophilic pressure sensitive adhesive was obtained.

The same procedure as in Example 1 was repeated except that this hydrophilic pressure sensitive adhesive was used in place of the acrylic pressure sensitive adhesive. The results are given in Table 1.

Comparative Example 1

A 60% toluene solution of styrene-vinylisoprene block copolymer (Hybrar VS-1 produced by Kuraray Co., Ltd.) was cast on the same support film as in Example 1 to thereby be dried at 100°C for 2 min without lamination and ultraviolet irradiation. Thus, a 300 μm thick substrate film having Young's modulus shown in Table 1 was obtained.
A pressure sensitive adhesive sheet was prepared from the obtained substrate film in the same manner as in Example 1. The results are given in Table 1.

Comparative Example 2

In place of the photocurable resin composition of Example 1, polyene/thiol resin (BY-314 produced by Asahi Denka Kogyo K.K.) was formed into a film and cured in the same manner as in Example 1, thereby obtaining a substrate film of 250 μm thickness. A pressure sensitive adhesive sheet was prepared from the obtained substrate film in the same manner as in Example 1. The results are given in Table 1.

Comparative Example 3

The same procedure as in Example 1 was repeated except that 110 μm thick low-density polyethylene film (trade name: Sumikathene L705) was used as the substrate film. The results are given in Table 1.

Comparative Example 4

The same procedure as in Example 1 was repeated except that 200 μm thick low-density polyethylene film (trade name: Sumikathene L705) was used as the substrate film. The results are given in Table 1.

Comparative Example 5

The same procedure as in Example 1 was repeated except that a 100 μm thick ethylene/vinyl acetate copolymer film (vinyl acetate content: 12%) was used as the substrate film and that the same hydrophilic (water soluble) pressure sensitive adhesive as in Example 4 was used as the pressure sensitive adhesive. The results are given in Table 1.

Comparative Example 6

The same procedure as in Example 1 was repeated except that a 100 μm thick polyethylene terephthalate film was used as the substrate film. The results are given in Table 1.

## Table 1

| | thick-ness (μm) | Substrate Young's modulus (Pa) | thickness x Young's mo-dulus (N/m) | thick-ness (μm) | Pressure sensiti-ve adhesive layer elastic modulus (Pa) | Pressure sensitive adhesive sheet stress rel-axation ra-tio (%) | Young's modulus (Pa) | Warpage of wafer (mm) after grind-ing | after immer-sion in 80°C water |
|---|---|---|---|---|---|---|---|---|---|
| Example 1 | 110 | $1.8 \times 10^8$ | $1.98 \times 10^4$ | 20 | $1.5 \times 10^5$ | 87 | $1.7 \times 10^8$ | 0.15 | 0.18 |
| 2 | 110 | $2.0 \times 10^8$ | $2.2 \times 10^4$ | 20 | $1.0 \times 10^5$ | 72 | $1.9 \times 10^8$ | 0.30 | 0.39 |
| 3 | 150 | $6.0 \times 10^7$ | $9.0 \times 10^3$ | 40 | $1.0 \times 10^5$ | 68 | $6.0 \times 10^7$ | 0.30 | 0.41 |
| 4 | 110 | $1.8 \times 10^8$ | $1.98 \times 10^4$ | 20 | $1.3 \times 10^6$ | 82 | $1.7 \times 10^8$ | 0.16 | 0.18 |
| Comp.Ex.1 | 300 | $1.0 \times 10^7$ | $3.0 \times 10^3$ | 20 | $1.5 \times 10^5$ | 18 | $1.0 \times 10^7$ | 1.12 | 2.63 |
| 2 | 250 | $1.2 \times 10^7$ | $3.0 \times 10^3$ | 20 | $1.5 \times 10^5$ | 12 | $1.2 \times 10^7$ | 1.24 | 2.83 |
| 3 | 110 | $1.2 \times 10^8$ | $1.43 \times 10^4$ | 20 | $1.5 \times 10^5$ | 14 | $1.3 \times 10^8$ | 1.45 | 3.54 |
| 4 | 200 | $1.3 \times 10^8$ | $2.60 \times 10^4$ | 40 | $1.5 \times 10^5$ | 14 | $1.3 \times 10^8$ | 1.51 | 6.16 |
| 5 | 120 | $6.0 \times 10^7$ | $7.2 \times 10^3$ | 10 | $1.3 \times 10^6$ | 9 | $5.0 \times 10^7$ | 1.82 | 6.53 |
| 6 | 100 | $3.5 \times 10^9$ | $3.5 \times 10^6$ | 10 | $1.5 \times 10^5$ | 30 | $3.5 \times 10^9$ | 0.92 | 3.90 |

## Claims

1. A method for grinding the back of a semiconductor wafer having a surface furnished with a circuit pattern, said method comprising;

   sticking onto the circuit surface of the wafer, a pressure sensitive adhesive sheet comprising a substrate and, superimposed thereon, a pressure sensitive adhesive layer, wherein said pressure sensitive adhesive sheet exhibits a one-minute-later stress relaxation ratio, at 10% elongation, of at least 40% in a tensile test, and

   grinding the back of the wafer to reduce the thickness of the wafer to 50 - 200 $\mu$m.

2. The method as claimed in claim 1, wherein the pressure sensitive adhesive sheet has a Young's modulus ranging from $3.0 \times 10^7$ to $5.0 \times 10^9$ Pa.

3. The method as claimed in claim 1 or claim 2, wherein the substrate has a Young's modulus and a thickness whose multiplication product is in the range of $1.0 \times 10^3$ to $1.0 \times 10^7$ N/m.

4. The method as claimed in any preceding claim, wherein the pressure sensitive adhesive layer is composed of a pressure sensitive adhesive whose elastic modulus as 23°C is in the range of $5.0 \times 10^4$ to $1.0 \times 10^8$ Pa.


## Patentansprüche

1. Verfahren zum Schleifen der Rückseite eines Halbleiterwafers der eine mit einer Leiterstruktur versehene Oberfläche besitzt, wobei das Verfahren umfasst;

   Aufkleben einer druckempfindlichen Klebefolie welche ein Substrat und darüberliegend eine druckempfindliche Klebstoffschicht umfasst, auf die Leiteroberfläche auf dem Wafer wobei die druckempfindliche Klebefolie in einem Zugtest bei 10 %-iger Dehnung ein eine-Minute-später-Spannungsrelaxationsverhältnis von mindestens 40 % aufweist, und

   Schleifen der Rückseite des Wafers um die Dicke des Wafers auf 50 - 200 $\mu$m zu verringern.

2. Verfahren nach Anspruch 1, wobei die druckempfindliche Klebefolie einen Young'schen Modul im Bereich von $3,0 \times 10^7$ bis $5,0 \times 10^9$ Pa aufweist.

3. Verfahren nach Anspruch 1 oder Anspruch 2, wobei das Substrat einen Young'schen Modul und eine Dicke aufweist, deren Multiplikations-Produkt im Bereich von $1,0 \times 10^3$ bis $1,0 \times 10^7$ N/m liegt.

4. Verfahren nach einem der vorhergehenden Ansprüche, wobei die druckempfindliche Klebstoffschicht aus einem druckempfindlichen Klebstoff besteht, dessen Elastizitätsmodul bei 23 °C im Bereich von $5,0 \times 10^4$ bis $1,0 \times 10^8$ Pa liegt.


## Revendications

1. Procédé de rodage de l'arrière d'une plaquette à semi-conducteur ayant une surface munie d'une configuration de circuit, le procédé consistant ;

   à coller sur la surface du circuit de la plaquette une pellicule adhésive autocollante comprenant un substrat et, lui étant superposée, une couche adhésive autocollante, la pellicule adhésive autocollante ayant un rapport de relaxation en contrainte une minute plus tard, à un allongement de 10 %, d'au moins 40 % dans un essai de traction, et

   à roder l'arrière de la plaquette pour réduire l'épaisseur de la plaquette jusqu'à 50 à 200 $\mu$m.

2. Procédé suivant la revendication 1, dans lequel la pellicule adhésive autocollante a un module d'Young compris entre $3,0 \times 10^7$ et $5,0 \times 10^9$ Pa.

3. Procédé suivant la revendication 1 ou la revendication 2, dans lequel le substrat a un module d'Young et une épaisseur dont le produit multiplicatif est compris entre $1,0 \times 10^3$ et $1,0 \times 10^7$ N/m.

4. Procédé suivant l'une quelconque des revendications précédentes, dans lequel la couche adhésive autocollante est composée d'un adhésif autocollant dont le module élastique à 23°C est compris entre $5,0 \times 10^4$ et $1,0 \times 10^8$ Pa.